# EUROPÄISCHE PATENTSCHRIFT

(11) **EP 0 315 161 B1**
(45) Veröffentlichungstag und Bekanntmachung des Hinweises auf die Patenterteilung: **28.02.1996**
(21) Anmeldenummer: 88118276.0
(22) Anmeldetag: 03.11.1988
(51) Int. Cl.: H05K 13/04

(54) **Vorrichtung zur Bestückung insbesondere von Leiterplatten**
Apparatus for mounting, especially on printed circuit boards
Dispositif de montage, notamment sur des circuits imprimés

(30) Priorität: 05.11.1987 DE 3737506
(43) Veröffentlichungstag der Anmeldung: 10.05.1989
(73) Patentinhaber: IBM DEUTSCHLAND GMBH, D-70569 Stuttgart (DE); International Business Machines Corporation, Armonk, N.Y. 10504 (US)
(72) Erfinder: Rager, Hans, D-7030 Böblingen (DE)
(74) Vertreter: Teufel, Fritz, Dipl.-Phys.

(56) Entgegenhaltungen:
- EP-A- 0 155 512
- EP-A- 0 195 086
- EP-A- 0 204 451
- EP-A- 0 213 746
- GB-A- 2 096 498

## Beschreibung

Die Erfindung betrifft eine Vorrichtung zur Bestückung insbesondere von Leiterplatten mit Teilen mit einem um eine Drehachse drehbaren Revolverkopf, der zwischen einer Abholstellung und einer Beschickungsstellung durch eine Steuerung gesteuert bewegbar ist, bei der der Revolverkopf über mehrere Teileaufnahmen Teile aufnehmen und in einer ggf. versenkten Bauteilzentrierung durch Unterdruck halten und gezielt montieren kann, wobei in dieser Bauteilzentrierung ein mit einer Unterdruckquelle verbindbarer Saugkanal (Saugröhrchen) mündet und mindestens eine der Teileaufnahmen mindestens zwischen einer vorgeschobenen Aufnahme/Ablagestellung und einer zurückgezogenen Halte/Transportstellung im Revolverkopf verschiebbar geführt ist und die anderen Teileaufnahmen in einer Transportstellung oder einer Ruhestellung im Revolverkopf gehalten sind, und in der Halte/Transportstellung der Saugkanal dauernd mit der Unterdruckquelle verbunden ist und in der Aufnahmestellung ebenfalls mit einer Unterdruckquelle verbunden und in der Ablagestellung von der Druckquelle getrennt ist und jede Teileaufnahme hülsenartig hohl ausgebildet in einer zugeordneten Führungsbohrung des Revolverkopfs verschiebbar geführt ist und ferner im Revolverkopf jeweils zwei im Abstand voneinander in die zugeordnete Führungsbohrung mündende Kanäle vorgesehen sind und in jeder Teileaufnahme eine Durchtrittsöffnung vorgesehen ist, die in der zurückgezogenen Halte/Transportstellung der Teileaufnahme mit dem oberen der beiden Kanäle und in der ausgefahrenen Aufnahme-/Ablagestellung der Teileaufnahme mit dem unteren der beiden Kanäle zusammenwirkt und jeweils den Innenraum der Teileaufnahme mit einem der Kanäle verbindet, wobei der Saugkanal teilweise durch ein über einen Kolben axial verschiebbares Saugröhrchen gebildet ist, das zwischen einer zurückgezogenen Haltelage und einer Abhol- und Beschickungsstellung, in der das freie Ende des Saugröhrchens die Bauteilzentrierung überragt, verschiebbar ist und ferner die Teileaufnahme einen im Durchmesser sich zum Ende hin verjüngenden Kopfteil aufweist, an dessen Ende die Bauteilzentrierung vorgesehen ist.

Eine solche Vorrichtung ist aus der EP-A-0 213 746 bekannt. Bei dieser bekannten Vorrichtung werden die zu montierenden Teilchen direkt von der Bauteilzentrierung aufgenommen und wieder abgesetzt. Die direkt mit der Bauteilzentrierung verbundene Masse ist relativ groß.

Aus der EP-A-0 204 451 ist es bekannt, eine Vorrichtung zum Bestücken insbesondere von Leiterplatten über einen Roboterarm gesteuert zu führen. Es wird so die Anzahl der ansteuerbaren Montageteile wesentlich erhöht bei geringem konstruktivem Aufwand.

In Vermeidung der geschilderten Nachteile liegt der vorliegenden Erfindung die Aufgabe zugrunde eine Vorrichtung der eingangs genannten Art so weiterzubilden, daß auch sehr berührungsempfindliche Teile ohne Beschädigung gehandhabt werden können.

Zur Lösung dieser Aufgabe sieht die Erfindung vor, daß der Revolverkopf über einen Roboterarm zwischen seiner Abholstellung und seiner Beschickungsstellung durch die Steuerung gesseuert bewegbar ist, daß der Kolben im Kopfteil verschiebbar geführt ist, daß das Saugröhrchen einseitig im Kolben gehalten und das freie Ende in einer abgesetzten, in der Bauteilzentrierung mündenden Bohrung angeordnet ist, wobei in der Abhol- und Beschickungsstellung das Saugröhrchen im durchmesserkleineren Teil der abgesetzten Bohrung geführt ist und in die Bauteilzentrierung ragt und in der zurückgezogenen Haltelage das Saugröhrchen mindestens bündig in der Bauteilzentrierung oder noch weiter zurückgezogen endet.

Die Saugröhrchen-Kolbenbaueinheit weist nur eine relativ geringe Masse auf, so daß ein aufzunehmendes Bauteil besonders sanft angesteuert und aufgenommen werden kann. Montageschäden können so minimiert werden.

In besonders vorteilhafter Weise kann der Saugkanal durch ein Rückschlagventil verschließbar sein, so daß mindestens über ein Teilstück der Saugkanal nur in einer Richtung und zwar in Absaugrichtung des Unterdrucks durchströmbar ist. Zweckmäßigerweise ist das Rückschlagventil im Kolben vorgesehen, vorzugsweise in Form einer in einer abgesetzten axialen Bohrung angeordneten Kugel, wobei der Absatz der axialen Bohrung als Dichtfläche mit der Kugel zusammenwirkt und eine Durchströmung des Saugröhrchens in Richtung zum freien Ende hin unterbindet. Die eigentliche Montage des Teilchens erfolgt über Druckluft. Die Druckluft wird in den Innenreum der Teileaufnahme eingeleitet, so daß durch die Druckluft der Kolben und damit auch das Saugröhrchen nach unten verschoben wird. Bei dieser Verschiebung ist im Saugröhrchen immer noch Unterdruck wirksam, so daß der Bauteil am freien Ende des Saugröhrchens noch festgehalten wird. Das Saugröhrchen selbst tritt dann aus der Bauteilzentrierung hervor und drückt den zu montierenden Teil an der Leiterplatte an, wo er bspw. durch ein Lötmittel haftet. Durch das Rückschlagventil wird gewährleistet, daß keine Druckluft nach unten austritt und evtl. benachbarte, bereits montierte Teile wegbläst. Die Haftwirkung der Teilchen durch die Lötpaste oder durch sonstige Haftmittel ist so groß, daß der Teil auf der Leiterplatte haftet und das Saugröhrchen trotz Unterdruckwirkung durch Zurückziehen der Teileaufnahme über den Stößel vom montierten Teil abgezogen werden kann.

Zweckmäßigerweise kann der das Saugröhrchen tragende Kolben unter Vorspannung im Kopfteil verschiebbar geführt sein, mit einer definierten Selbsthemmkraft. Hierdurch kann die Andrückkraft bei der Montage ohn zusätzliche Maßnahmen begrenzt und damit eine Beschädigung der zu montierend Teile vermieden werden.

Zur Energieeinsparung können in einer mittleren Neutralstellung der Teilaufnahme die beiden zugeordneten Kanäle des Revolverkopfs durch die Wandung der Teileaufnahme verschlossen sein, so daß weder eine Verbindung zur Vakuumquelle noch zur Druckquelle vorhanden ist. Die gerade nicht im Einsatz befindlichen Teileaufnahmen werden in dieser Neutralstellung im Revolverkopf durch ihre Eigenreibung und ggf. durch die zusätzliche definierte Wirkung eines Hemmrings gehalten.

Weitere erfindungsgemäße Ausbildungen sind den Unteransprüchen zu entnehmen und werden mit ihren Vorteilen anhand der beigefügten Zeichnungen näher erläutert. Es zeigt:
- Figur 1: eine stark schematisierte Ansicht einer Vorrichtung zum Bestücken,
- Figur 2: einen vereinfachten Schnitt durch einen Revolverkopf entlang der Linie II-II in Figur 1,
- Figur 3: einen Schnitt durch einen Revolverkopf mit zwei Teileaufnahmen in verschiedenen Arbeitslagen in größerem Maßstab.

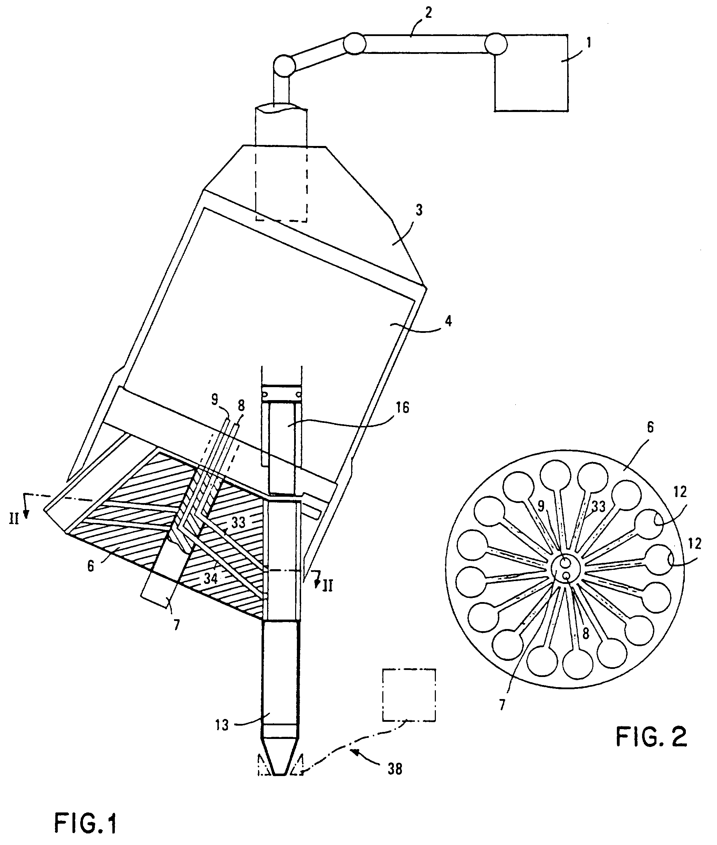

Die in Figur 1 schematisiert dargestellte Vorrichtung zum Bestücken insbesondere von Leiterplatten besteht aus einem Roboter 1 mit Steuerung, einem Roboterarm 2, an dessen Ende eine Montageeinheit 3 angeordnet ist, die selbst einen Trägerkopf 4 und einen um eine Drehachse 5 drehbaren Revolverkopf 6 aufweist. Im Trägerkopf 4 ist ein den Revolverkopf 6 tragender Führungsbolzen 7 angeordnet, der in Längsbohrungen zwei Verbindungskanäle 8, 9 aufweist. Der Verbindungskanal 8 ist dauernd mit einer nicht näher dargestellten Unterdruckquelle verbunden, während der Verbindungskanal 9 über ein Ventil 10 wahlweise mit der eben angeführten oder einer anderen Unterdruckquelle oder mit einer ebenfalls nicht dargestellten Druckluftquelle verbindbar ist.

Der Revolverkopf 6 selbst ist kreiskegelstumpfförmig ausgebildet und hat nahe seiner Mantelfläche 11 am Umfang verteilt Führungsbohrungen 12 für im Ausführungsbeispiel sechzehn Teileaufnahmen 13. Diese Teileaufnahmen 13 sind in den Führungsbohrungen 12 verschiebbar geführt, wobei die Endlagen jeweils durch einen Anschlaglänzsschlitz 14 und einen Anschlagstift 15 begrenzt sind. Der Anschlagstift 15 dient gleichzeitig auch noch als Verdrehsicherung.

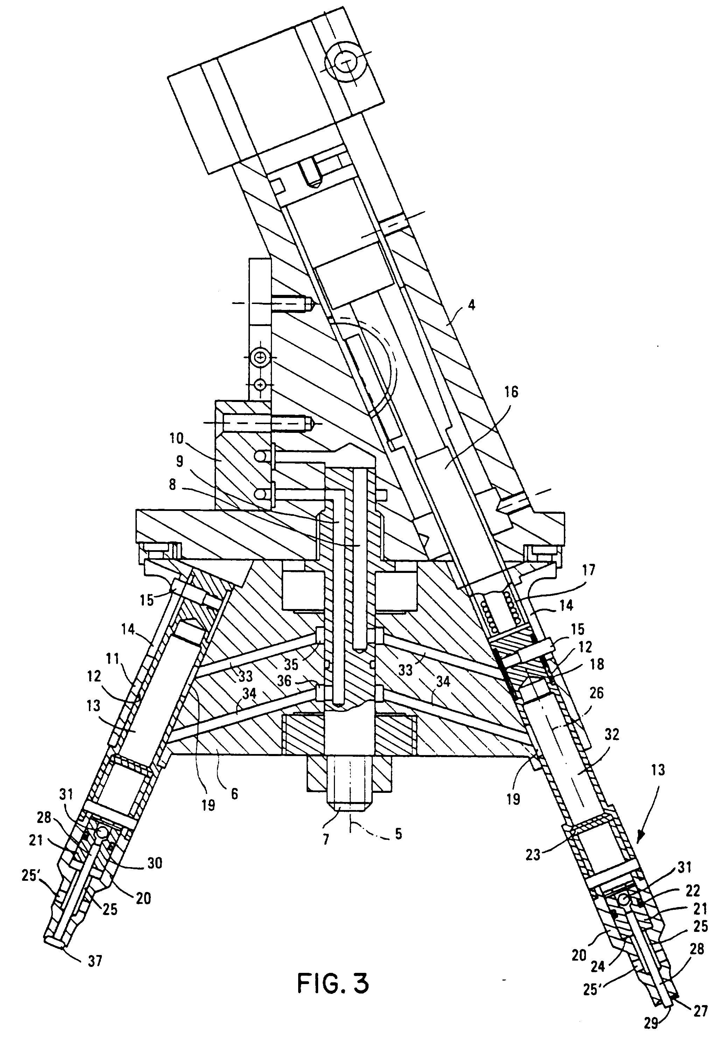

Im Trägerkopf 4 ist über einen Elektromotor ein Stößel 16 in Richtung der Führungsbohrung 12 verschiebbar geführt und über eine Magnetspule mit einer zugeordneten Teileaufnahme 13 magnetisch über einen Haltemagnet 17 koppelbar. Die Teileaufnahme 13 kann zwischen der in Figur 3 rechts dargestellten Aufnahme/Ablagestellung und der in Figur 3 links dargestellten Halte/Transportstellung geschwindigkeitsgesteuert verschoben werden und zwar nur in der Stellung des Revolverkopfs 6, in der die Teileaufnahme 13 zum Stößel 16 fluchtet. Hierzu kann der Revolverkopf 6 exakt drehpositioniert werden, wobei durch die Steuerung ausgewählt jeweils nur eine der Teileaufnahmen 13 bewegt werden kann. Die übrigen im Revolverkopf 6 angeordneten Teileaufnahmen 13 beharren in ihrer einmal durch den Stößel 16 vorgegebenen Lage. Um ein Verrutschen in der Führungsbohrung 12 zu verhindern, ist am Außenumfang der Teileaufnahme 13 jeweils ein Hemmring 18 vorgesehen, der einen definierten Widerstand gegen Verschieben in der Führungsbohrung 12 gewährleistet, bspw. zwischen etwa 1 und 1,5 N (100 und 150 Pond).

Die Teileaufnahme 13 selbst ist hülsenartig im wesentlichen hohl ausgebildet und weist eine dem Revolverkopf 6 zugekehrte Durchtrittsöffnung 19 in Form eines Schlitzes auf. In einem Kopfteil 20 ist ein Kolben 21 verschiebbar geführt, wobei durch einen Dichtring 22 zum Verschieben eine gewisse Mindestverstellkraft von bspw. etwa 0,5 bis 1 N (50 bis 100 p) erforderlich ist. Der Kolben 21 ist zwischen einem Anschlagstift 23 und einem Absatz 24 bewegbar. Der Anschlagstift 23 sichert zusätzlich den oberen Teil der Teileaufnahme 13 und den Kopfteil 20. Anschließend an den Absatz 24 ist eine abgesetzte axiale Bohrung 25 fluchtend zur Achse 26 vorgesehen, die in einer Bauteilzentrierung 27 am Ende der Teileaufnahme 13 mündet. Die Bauteilzentrierung 27 kann entsprechend den zu montierenden Teile geformt sein.

Konzentrisch im Kolben 21 ist auf einer Kolbenseite hervorstehend ein Saugröhrchen 28 vorgesehen, das in der in Figur 3 rechts unten gezeigten Abhol- und Bestückungsstellung die Bauteilzentrierung 27 mit seinem freien Ende 29 durchragt, während in der zurückgezogenen Haltelage, die in Figur 3 links dargestellt ist, der Kolben 21 am Anschlagstift 23 anliegt. Der Raum 30 unterhalb des Kolbens 21 ist durch eine Belüftungsbohrung 25' direkt mit der Umgebung in Verbindung, so daß sich der Kolben 21 ungehindert mit einem Hub von ca. 2 mm bewegen kann.

Im Kolben 21 ist noch ein Rückschlagventil 31 in Form eines Kugelventils vorgesehen, das nur eine Durchströmung des Saugröhrchens 28 zum Innenraum 32 der Teileaufnahme 13 zuläßt, nicht aber eine entgegengesetzte Durchströmung.

Im Revolverkopf 6 sind jeweils paarweise Kanäle 33 und 34 angeordnet, die jeweils in einem Ringkanal 35 bzw. 36 münden. Der Ringkanal 36 ist durch eine Querbohrung mit dem Verbindungskanal 9 und der Ringkanal 35 ebenfalls über eine Querbohrung mit den Verbindungskanal 8 in Verbindung.

Über den Verbindungskanal 8, den Ringkanal 35 und die oberen Kanäle 33 sind die Innenräume 32 aller sich in ihrer Halte/Transportstellung befindlichen Teileaufnahme 13 dauernd mit einer Unterdruckquelle in Verbindung, so daß durch den Unterdruck durch den Kolben 21 und das Saugröhrchen 28 hindurch Teile 37 an der Bauteilzentrierung 27 festgesaugt und so sicher festgehalten sind, wie dies in Figur 3 links dargestellt ist.

In der in Figur 3 rechts dargestellten Aufnahme/Ablagestellung ist bei der Aufnahme von einem Bauteil das freie Ende 29 des Saugröhrchens 28 über den Kolben 21, den Innenraum 32, die Durchtrittsöffnung 19, den unteren Kanal 34 mit dem Ringkanal 36 verbunden, der seinerseits über den Verbindungskanal 9 mit einer nicht näher dargestellten Unterdruckquelle verbunden ist. Durch den Unterdruck wird ein aufzunehmender nicht dargestellter Teil 37 angesaugt. Zur Schonung der Teile 37 kann durch die Vorgabe der Verschiebegeschwindigkeit der Teileaufnahme 13 der aufzunehmende Teil 37 sanft durch das Saugröhrchen 28 angefahren werden. Das freie Ende 29 des Saugröhrchens 28 wird durch den aufgenommen Teil 37 verschlossen, so daß durch den ansteigenden Unterdruck im Innenraum 32 der Kolben 21 nach oben verschoben wird. Dadurch wird über das Saugröhrchen 28 der aufgenommene Teil 37 in die Bauteilzentrierung 27 gezogen und dort durch den Unterdruck gehalten. Durch den Stößel 16 wird dann die Teileaufnahme 13 in die in Figur 3 links dargestellte Halte/Transportstellung gebracht.

Umgekehrt wird zum Bestücken einer Leiterplatte nach dem Anfahren der Bestückungsstelle an der Leiterplatte durch den Trägerkopf 4 von der Steuerung des Roboters 2 gesteuert, der Stößel 16 nach unten verschoben, so daß der in Figur 3 dort nicht dargestellte zu montierende Teil in seine Montagelage kommt. Dann wird das Ventil 10 umgeschaltet und in den Verbindungskanal 9 Druckluft eingeblasen, die dann über den Ringkanal 36, den unteren Kanal 34, die Durchtrittsöffnung 19 in den Innenraum 32 gelangt und den Kolben 21 nach unten verschiebt. Durch den ansteigenden Druck wird das Rückschlagventil 31 geschlossen, so daß keine Druckluft nach außen durch das Saugröhrchen 28 austreten kann und evtl. bereits positionierte Teile weggeblasen werden. Die Haftkraft der Bauteile auf den Leiterplatten ist durch Lötmittel oder sonstige Haftmittel so groß, daß eine Trennung vom aus der Bauteilzentrierung 27 vorstehenden freien Ende 29 des Saugröhrchens 28 ohne weiteres trotz des dort noch vorhandenen Unterdrucks möglich ist. Durch das nach außen tretende freie Ende 29 des Saugröhrchens 28 wird der zu montierende Teil auf der Leiterplatte fest angedrückt, wobei dann anschließend die Teileaufnahme 13 über den Stößel 16 in eine in den Figuren nicht dargestellte Ruhestellung gebracht wird, in der die Durchtrittsöffnung 19 zwischen den Kanälen 33 und 34 zu liegen kommt, so daß diese Kanäle durch die Wandung der Teileaufnahme 13 abgeschlossen sind und praktisch keine Leckverluste auftreten. Wenn dann alle Teile 37 montiert sind, fährt der Trägerkopf 4 wieder zu einer Abholstation um mit neuen Teilen 37 bestückt zu werden. In einem Arbeitsgang können daher wegsparend jeweils eine Gruppe von sechzehn Bauteilen 37 montiert werden.

Zum exakten Anfahren der Montagestelle kann, wie in Figur 1 strichpunktiert angedeutet eine optische Hilfe 38 vorgesehen sein, durch die eine noch wesentlich exaktere Ansteuerung auch evtl. bei großen Maßtoleranzen ermöglicht wird.

## Patentansprüche

1. Vorrichtung zur Bestückung insbesondere von Leiterplatten mit Teilen (37) mit einem um eine Drehachse (5) drehbaren Revolverkopf (6), der zwischen einer Abholstellung und einer Beschickungsstellung durch eine Steuerung gesteuert bewegbar ist, bei der der Revolverkopf (6) über mehrere Teileaufnahmen (13) Teile (37) aufnehmen und in einer ggf. versenkten Bauteilzentrierung (27) durch Unterdruck halten und gezielt montieren kann, wobei in dieser Bauteilzentrierung (27) ein mit einer Unterdruckquelle verbindbarer Saugkanal mündet und mindestens eine der Teileaufnahmen (13) mindestens zwischen einer vorgeschobenen Aufnahme/Ablagestellung und einer zurückgezogenen Halte/Transportstellung im Revolverkopf (6) verschiebbar geführt ist und die anderen Teileaufnahmen (13) in einer Transportstellung oder einer Ruhestellung im Revolverkopf (6) gehalten sind, und in der Halte/Transportstellung der Saugkanal dauernd mit der Unterdruckquelle verbunden ist und in der Aufnahmestellung ebenfalls mit einer Unterdruckquelle verbunden und in der Ablagestellung von der Druckquelle getrennt ist und jede Teileaufnahme (13) hülsenartig hohl ausgebildet in einer zugeordneten Führungsbohrung (12) des Revolverkopfs (6) verschiebbar geführt ist und ferner im Revolverkopf (6) jeweils zwei im Abstand voneinander in die zugeordnete Führungsbohrung (12) mündende Kanäle (33, 34) vorgesehen sind und in jeder Teileaufnahme (13) eine Durchtrittsöffnung (19) vorgesehen ist, die in der zurückgezogenen Halte/Transportstellung der Teileaufnahme (13) mit dem oberen (33) der beiden Kanäle (33, 34) und in der ausgefahrenen Aufnahme-/Ablagestellung der Teileaufnahme (13) mit dem unteren (34) der beiden Kanäle (33, 34) zusammenwirkt und jeweils den Innenraum (32) der Teileaufnahme (13) mit einem der Kanäle (33 oder 34) verbindet, wobei der Saugkanal teilweise durch ein über einen Kolben (21) axial verschiebbares Saugröhrchen (28) gebildet ist, das zwischen einer zurückgezogenen Haltelage und einer Abhol- und Beschickungsstellung, in der das freie Ende (29) des Saugröhrchens (28) die Bauteilzentrierung (27) überragt, verschiebbar ist und ferner die Teileaufnahme (12) einen im Durchmesser sich zum Ende hin verjüngenden Kopfteil (20) aufweist, an dessen Ende die Bauteilzentrierung (27) vorgesehen ist, **dadurch gekennzeichnet**, daß der Revolverkopf (6) über einen Roboterarm (2) zwischen seiner Abholstellung und seiner Beschickungsstellung durch die Steuerung gesteuert bewegbar ist, daß der Kolben (21) im Kopfteil (20) verschiebbar geführt ist, daß das Saugröhrchen (28) einseitig im Kolben (21) gehalten und das freie Ende (29) in einer abgesetzten in der Bauteilzentrierung (27) mündenden Bohrung (25) angeordnet ist, wobei in der Abhol- und Beschickungsstellung das Saugröhrchen (28) im durchmesserkleineren Teil der abgesetzten Bohrung (25) geführt ist und in die Bauteilzentrierung (28) ragt und in der zurückgezogenen Haltelage das Saugröhrchen (28) mindestens bündig in der Bauteilzentrierung (28) oder noch weiter zurückgezogen endet.

2. Vorrichtung nach Anspruch 1, dadurch gekennzeichnet, daß der Saugkanal durch ein Rückschlagventil (31) verschließbar ist.

3. Vorrichtung nach Anspruch 2, dadurch gekennzeichnet, daß das Rückschlagventil (31) im Kolben (21) vorgesehen ist, vorzugsweise in Form einer in einer abgesetzten axialen Bohrung angeordneten Kugel, wobei der Absatz der axialen Bohrung als Dichtfläche mit der Kugel zusammenwirkt und eine Durchströmung des Saugröhrchens (28) in Richtung zum freien Ende (29) hin unterbindet.

4. Vorrichtung nach Anspruch 1, dadurch gekennzeichnet, daß in der Ablagestellung der Teileaufnahme (13) der Innenraum (32) dieser Teileaufnahme (13) druckluftbeaufschlagt ist und der Kolben (21) mit dem Saugröhrchen (28) zur Bauteilzentrierung (27) hin verschoben und dadurch der zu montierende Teil (37) von der Bauteilzentrierung (27) durch das freie Ende (29) des Saugröhrchens (28) weggedrückt und auf seinem Montageplatz angedrückt wird.

5. Vorrichtung nach einem der Ansprüche 1 bis 4, dadurch gekennzeichnet, daß der das Saugröhrchen (28) tragende Kolben (21) unter Vorspannung im Kopfteil (20) verschiebbar geführt ist mit einer definierten Selbsthemmekraft.

6. Vorrichtung nach Anspruch 5, dadurch gekennzeichnet, daß die Selbsthemmekraft etwa 0,5 N (50 Pond) beträgt.

7. Vorrichtung nach einem der Ansprüche 1 bis 6, dadurch gekennzeichnet, daß in einer mittleren Ruhestellung der Teileaufnahme (13) die beiden zugeordneten Kanäle (33, 34) des Revolverkopf (6) durch die Wandung der Teileaufnahme (13) verschlossen sind.

8. Vorrichtung nach Anspruch 7, dadurch gekennzeichnet, daß diese Ruhestellung der Teileaufnahme (13) nach einem Ablegen eines Teils durch den elektromotorisch gesteuerten Stößel (16) eingestellt wird un der Halteteil (13) erst wieder zur Aufnahme eines Teils (37) durch den Stößel (16) in seine Aufnahmestellung und anschließend in seine Halte/Transportstellung verschoben wird.

9. Vorrichtung nach einem der Ansprüche 1 bis 8, dadurch gekennzeichnet, daß im Bereich der Bauteilzentrierung (27) eine optische Hilfe (38) vorgesehen ist.

## Claims

1. An assembly apparatus, particularly suitable for mounting components (37) on printed circuit boards, comprising a turret (6), which can be rotated about an axis (5) and moved by a controller between a pick-up position and a placement position, where the turret (6) uses several component pick-up effectors (13) to pick up components (37), holding them by suction in a component alignment fixture (27), retractable if required, and mounting them at target positions, whereby a suction channel, connectable to a vacuum source, leads into this component alignment fixture (27), and at least one of the component pick-up effectors (13) can be moved between at least one extended pick-up/set down position and one retracted holding/transport position in the turret (6) whilst the other pick-up effectors (13) are held in a transport or idle position in the turret (6), the suction channel being permanently connected to the vacuum source at the holding/transport and at the pick-up positions, but disconnected from the compressed air source at the set down position, and whereby each pick-up effector (13), designed like a hollow barrel, slides inside an associated guide hole (12) in the turret (6), there being, furthermore, two separate ducts (33, 34) leading into each hole (12), and in each component effector (13) there is a port (19) which interacts with the upper (33) of the two ducts(33, 34) in the retracted holding/transport position of the effector (13), and with the lower (34) of the two ducts (33, 34) in the extended pick-up/set down position of the effector (13), linking the interior (32) of the component effector (13) with one of the ducts (33 or 34) in each case, whereby the suction channel is formed partly by a suction capillary tube (28) slid axially by means of a piston (21) moving between a retracted holding position and a pick-up and placement position, in which the open end (29) of the suction tube (28) projects beyond the component alignment fixture (27), and
furthermore, the component effector (13) exhibits a nose-piece (20) tapering towards the end, where the component alignment fixture (27) is provided, with the feature that the turret (6) can be moved by the controller between its pick-up position and its placement position by means of a robot arm (2), with the feature that the piston (21) slides in the nose-piece (20), with the feature that the suction capillary tube (28) is retained in one face of the piston (21), its open end (29) being located in a shouldered bore (25) leading into the component alignment fixture (27) whereby, in the pick-up and placement positions, the suction capillary (28) leads through the part of the shouldered bore (25) of narrower diameter and projects into the component alignment fixture (27) and, in the retracted holding position, the suction capillary (28) is retracted at least flush with, or even further recessed into, the component alignment fixture (27).

2. The apparatus conforming to Claim 1, with the feature that the suction channel may be sealed by a non-return valve (31).

3. The apparatus conforming to Claim 2, with the feature that the non-return valve (31) is provided in the piston (21), preferably in the form of a sphere located in a shouldered axial borehole, whose shoulder acts together with the sphere to form a seal, choking off the flow through the suction capillary (28) towards the open end (29).

4. The apparatus conforming to Claim 1, with the feature that, in the set down position of the component pick-up effector (13), compressed air is applied to the interior (32) of this effector (13), and the piston (21) together with the suction capillary (28) is displaced towards the component alignment fixture (27), with the result that the pressure pushes the component to be mounted (37) away from the component alignment fixture (27), through the open end (29) of the suction capillary (28), and locates it at its mounting position.

5. The apparatus conforming to Claims 1 to 4 , with the feature that the piston (21) carrying the suction capillary tube (28) is bias controlled to slide in the carrier head (20) at a defined self-locking force.

6. The apparatus conforming to Claim 5, with the feature that the self-locking force has a magnitude of approximately 0.5 N (50 gm. wt.).

7. The apparatus conforming to any of the Claims 1 to 6, with the feature that in a central idle position of the component pick-up effector (13), the two ducts (33, 34) associated with the turret (6) are shut off by the walls of the effector (13).

8. The apparatus conforming to Claim 7, with the feature that after a component has been placed, the component pick-up effector (13) is set in this idle position by a ram (16), driven by an electric motor, and the effector (13) is not moved by the ram (16) until it is again in its pick-up position for picking up a component (37) and, subsequently, in its holding/transport position.

9. The apparatus conforming to Claims 1 to 8, with the feature that an optical aid (38) is provided in the region of the component alignment fixture (27).

## Revendications

1. Dispositif destiné à garnir notamment des cartes imprimées avec des composants (37), grâce à une tête revolver (6) pouvant pivoter autour d'un axe de rotation (5), cette tête revolver pouvant être déplacée entre une position d'enlèvement et une position d'alimentation au moyen d'une commande, la tête revolver (6) pouvant recueillir plusieurs composants (37) grâce à plusieurs logements de composants (13) et les maintenir, le cas échéant, en un centrage des composants (27) affleurant et les monter de façon précise grâce à une dépression, un canal d'aspiration raccordable à une source de dépression débouchant dans ce centrage des composants (27) et au moins un des logements de composants (13) pouvant être déplacé au minimum entre une position de réception/dépôt avancée et une position de maintien/transport retirée dans la tête revolver (6) et les autres logements de composants (13) étant maintenus dans une position de transport ou de repos dans la tête revolver (6) et le canal d'aspiration étant en permanence relié à la source de dépression en position de maintien/transport, de même qu'en position de réception, mais étant séparé de la source de pression en position de dépôt et chaque logement de composant (13) réalisé sous forme de douille creuse pouvant être déplacé dans une forure de guidage (12) de la tête revolver (6) et deux canaux (33, 34) débouchant à quelque distance l'un de l'autre dans la forure de guidage afférente (12) étant par ailleurs prévus dans la tête revolver (6) et une ouverture de passage (19) étant prévue dans chaque logement de composant (13) qui agit avec le canal supérieur (33) des deux canaux (33, 34) en position de maintien/transport retirée du logement de composants (13) et avec le canal inférieur (34) des deux canaux (33, 34) en position de réception/dépôt déployée des logements de composants (13) et reliant à chaque fois l'intérieur (32) du logement de composant (13) à l'un des canaux (33, 34), le canal d'aspiration étant partiellement constitué d'un tube aspirant (28) pouvant être déplacé en direction axiale par un piston (21), ce tube aspirant pouvant être déplacé entre une position de maintien retirée et une position d'enlèvement et d'alimentation, dans laquelle l'extrémité libre (29) du tube aspirant (28) dépasse le centrage des composants (27) et le logement de composant (13) présentant par ailleurs un élément de tête (20) dont le diamètre va en s'amincissant vers l'extrémité, le centrage des composants (27) étant prévu à l'extrémité de cet élément, caractérisé en ce que la tête revolver (6) peut être déplacée entre sa position d'enlèvement et sa position d'alimentation par la commande au moyen d'un bras automatique (2), en ce que le piston (21) peut être déplacé dans l'élément de tête (20), en ce que le tube aspirant (28) est maintenu d'un côté dans le piston (21) et en ce que l'extrémité libre (29) est agencée dans une forure (25) étagée débouchant dans le centrage des composants (27), le tube aspirant (28) étant dirigé en position d'enlèvement et d'alimentation dans la partie de plus faible diamètre de la forure (25) étagée et dépassant dans le centrage des composants (27) et le tube aspirant (28) se terminant au moins à fleur dans le centrage des composants (27) ou encore plus en retrait, en position de maintien retirée.

2. Dispositif selon la revendication 1, caractérisé en ce que le canal d'aspiration peut être fermé par un clapet antiretour (31).

3. Dispositif selon la revendication 2, caractérisé en ce que le clapet antiretour (31) est prévu dans le piston (21), de préférence sous forme d'une bille agencée dans une forure axiale étagée, l'épaulement de la forure axiale agissant comme un joint avec la bille, empêchant tout passage de courant à l'intérieur du tube aspirant (28) en direction de l'extrémité libre (29).

4. Dispositif selon la revendication 1, caractérisé en ce que l'espace intérieur (32) du logement de composant (13) est sous pression d'air en position de dépôt du logement des composant (13) et en ce que le piston (21) est déplacé avec le tube aspirant (28) vers le centrage des composants (27) et en ce que le composant devant être monté (37) est refoulé du centrage des composants (27) par l'extrémité libre (29) du tube aspirant (28) pour être appliqué sur son emplacement de montage.

5. Dispositif selon l'une des revendications 1 à 4, caractérisé en ce que le piston (21) supportant le tube aspirant (28) peut être déplacé sous précontrainte dans l'élément de tête (20) avec une force de blocage automatique définie.

6. Dispositif selon la revendication 5, caractérisé en ce que la force de blocage automatique s'élève à environ 0,5 N (50 Pond).

7. Dispositif selon l'une des revendications 1 à 6, caractérisé en ce que les deux canaux affectés (33, 34) de la tête revolver (6) sont fermés par la paroi du logements de composant (13) en une position de repos médiane du logement de composant (13).

8. Dispositif selon la revendication 7, caractérisé en ce que cette position de repos du logement de composant (13) est réglée après dépôt d'un composant par le coulisseau (16) à commande électromotrice et en ce que l'élément de maintien (13) est d'abord déplacé par le coulisseau (16) en sa position de réception puis de maintien/transport, pour pouvoir recevoir un composant (37).

9. Dispositif selon l'une des revendications 1 à 8, caractérisé en ce qu'une aide visuelle (38) a été prévue dans la région du centrage des composants (27).
